(19) **Europäisches Patentamt / European Patent Office / Office européen des brevets**

(11) **EP 4 679 646 A1**

(12) # EUROPEAN PATENT APPLICATION

(43) Date of publication:
**14.01.2026 Bulletin 2026/03**

(21) Application number: **25186220.7**

(22) Date of filing: **30.06.2025**

(51) International Patent Classification (IPC):
**H01S 5/20** $^{(2006.01)}$   **H01S 5/187** $^{(2006.01)}$
**H01S 5/11** $^{(2021.01)}$   **H01S 5/042** $^{(2006.01)}$

(52) Cooperative Patent Classification (CPC):
**H01S 5/11; H01S 5/04252; H01S 5/04254;**
**H01S 5/04256; H01S 5/187; H01S 5/2027**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.07.2024 JP 2024110402**

(71) Applicants:
- **SUMITOMO ELECTRIC INDUSTRIES, LTD.**
  **Osaka-shi, Osaka 541-0041 (JP)**
- **Kyoto University**
  **Kyoto-shi, Kyoto 606-8501 (JP)**

(72) Inventors:
- **Ogasawara, Makoto**
  **Osaka-shi, Osaka, 541-0041 (JP)**
- **Kono, Naoya**
  **Osaka-shi, Osaka, 541-0041 (JP)**
- **Noda, Susumu**
  **Kyoto-shi, Kyoto, 606-8501 (JP)**
- **De Zoysa, Menaka**
  **Kyoto-shi, Kyoto, 606-8501 (JP)**
- **Inoue, Takuya**
  **Kyoto-shi, Kyoto, 606-8501 (JP)**
- **Yoshida, Masahiro**
  **Kyoto-shi, Kyoto, 606-8501 (JP)**
- **Ishizaki, Kenji**
  **Kyoto-shi, Kyoto, 606-8501 (JP)**

(74) Representative: **Grünecker Patent- und Rechtsanwälte**
**PartG mbB**
**Leopoldstraße 4**
**80802 München (DE)**

(54) ## PHOTONIC-CRYSTAL SURFACE EMITTING LASER AND METHOD OF MANUFACTURING THE SAME

(57)    A photonic-crystal surface emitting laser (100, 200, 300, 400) includes a first semiconductor layer (12), an active layer (18) stacked over the first semiconductor layer, a second semiconductor layer (22) provided opposite to the first semiconductor layer with respect to the active layer, a photonic crystal layer (14) provided between the first semiconductor layer and the second semiconductor layer, a first electrode (24) electrically connected to the first semiconductor layer, an insulating film (23) provided on a surface of the second semiconductor layer opposite to the active layer, and a second electrode (26) provided at a surface of the insulating film opposite to the second semiconductor layer. The photonic crystal layer has a first region (30) and a plurality of second regions (32, 34) each having a refractive index different from a refractive index of the first region. The insulating film has a plurality of openings (27). The second electrode is electrically connected to the second semiconductor layer at the plurality of openings.

FIG. 3B

EP 4 679 646 A1

## Description

TECHNICAL FIELD

The present disclosure relates to a photonic-crystal surface emitting laser and a method of manufacturing the same.

BACKGROUND

A photonic-crystal surface emitting laser (PCSEL) in which a photonic-crystal and an active layer having an optical gain are stacked is known (see Patent Literature: International Publication Pamphlet No. WO 2016/031966).

SUMMARY

An electrode is provided on a surface of a semiconductor layer. Light generated in an active layer is reflected from the electrode, whereby the light can be extracted. However, the output is reduced due to the scattering of light. Thus, an object of the present disclosure is to provide a photonic-crystal surface emitting laser and a method of manufacturing the photonic-crystal surface emitting laser that are capable of increasing optical output.

(1) A photonic-crystal surface emitting laser according to the present disclosure includes a first semiconductor layer, an active layer stacked over the first semiconductor layer, a second semiconductor layer provided opposite to the first semiconductor layer with respect to the active layer, a photonic crystal layer provided between the first semiconductor layer and the second semiconductor layer, a first electrode electrically connected to the first semiconductor layer, an insulating film provided on a surface of the second semiconductor layer opposite to the active layer, and a second electrode provided at a surface of the insulating film opposite to the second semiconductor layer. The photonic crystal layer has a first region and a plurality of second regions each having a refractive index different from a refractive index of the first region. The insulating film has a plurality of openings. The second electrode is electrically connected to the second semiconductor layer at the plurality of openings. Since the insulating film is provided between the second electrode and the second semiconductor layer, a contact area between the second electrode and the second semiconductor layer is reduced. A lower surface of the second electrode is less likely to be roughened, and the reflectivity is increased. The phase of light is adjusted by a thickness of the insulating film. The optical output can be increased.

(2) In the above configuration (1), the plurality of openings may be periodically provided in the surface of the insulating film. The current can be injected uniformly.

(3) In the above configuration (1) or (2), an area filling factor of the plurality of openings to a region where the second semiconductor layer is provided may be 5% to 50%. Contact resistance can be reduced and reflectivity can be increased.

(4) In any one of the above configurations (1) to (3), the plurality of openings may each have a rectangular planar shape and may each have a length of 1 $\mu$m to 10 $\mu$m. The opening can be easily manufactured. It is possible to make the current nearly uniform.

(5) In any one of the above configurations (1) to (4), the second electrode may include a first metal layer and a second metal layer. The second metal layer may have a reflectivity higher than a reflectivity of the first metal layer. The first metal layer may be provided at the plurality of openings in the insulating film, and the second metal layer may be provided on the surface of the insulating film. By increasing the reflectivity, the optical output can be increased.

(6) In any one of the above configurations (1) to (5), the photonic-crystal surface emitting laser may include a third semiconductor layer provided between the active layer and the second semiconductor layer. The first semiconductor layer may have an n-type conductivity. The second semiconductor layer and the third semiconductor layer may each have a p-type conductivity. A p-i-n junction is formed. The second electrode is connected to the second semiconductor layer through the opening. Carriers can be injected into the active layer.

(7) A method of manufacturing a photonic-crystal surface emitting laser according to the present disclosure includes: stacking an active layer over a first semiconductor layer; forming a photonic crystal layer; forming a second semiconductor layer opposite to the first semiconductor layer with respect to the active layer; forming a first electrode electrically connected to the first semiconductor layer; forming an insulating film on a surface of the second semiconductor layer opposite to the active layer; forming a plurality of openings in the insulating film; and forming a second electrode at a surface of the insulating film opposite to the second semiconductor layer. The photonic crystal layer has a first region and a plurality of second regions each having a refractive index different from a refractive index of the first region. The second electrode is electrically connected to the second semiconductor layer at the plurality of openings. Since the insulating film is provided between the second electrode and the second semiconductor layer, a contact area between the second electrode and the second semiconductor layer is reduced. The lower surface of the second electrode is less likely to be roughened, and the reflectivity is increased. The phase of light is adjusted by the thickness of the insulating film. The optical output can be increased.

(8) In the above configuration (7), the method of manufacturing a photonic-crystal surface emitting laser may include stacking a third semiconductor layer on the active layer. The second semiconductor layer may be stacked over the third semiconductor layer. In the forming of the insulating film, the insulating film having a thickness determined based on a thickness from the active layer to the second semiconductor layer may be formed. The phase of light can be adjusted and the optical output can be increased by controlling the thickness of the insulating film.

BRIEF DESCRIPTION OF THE DRAWINGS

FIG. 1 is a cross-sectional view illustrating a photonic-crystal surface emitting laser according to a first embodiment.
FIG. 2A is a plan view illustrating a photonic crystal layer.
FIG. 2B is an enlarged plan view of a region of the photonic crystal layer.
FIG. 2C is an enlarged cross-sectional view of a photonic crystal layer.
FIG. 3A is a lower surface view illustrating a photonic-crystal surface emitting laser.
FIG. 3B is an upper surface view illustrating a photonic-crystal surface emitting laser.
FIG. 4 is a diagram illustrating slope efficiency.
FIG. 5A is a cross-sectional view illustrating a method of manufacturing a photonic-crystal surface emitting laser.
FIG. 5B is a cross-sectional view illustrating a method of manufacturing a photonic-crystal surface emitting laser.
FIG. 5C is a cross-sectional view illustrating a method of manufacturing a photonic-crystal surface emitting laser.
FIG. 6A is a cross-sectional view illustrating a method of manufacturing a photonic-crystal surface emitting laser.
FIG. 6B is a cross-sectional view illustrating a method of manufacturing a photonic-crystal surface emitting laser.
FIG. 6C is a cross-sectional view illustrating a method of manufacturing a photonic-crystal surface emitting laser.
FIG. 7A is a cross-sectional view illustrating a method of manufacturing a photonic-crystal surface emitting laser.
FIG. 7B is a cross-sectional view illustrating a method of manufacturing a photonic-crystal surface emitting laser.
FIG. 8 is a cross-sectional view illustrating a photonic-crystal surface emitting laser according to a second embodiment.
FIG. 9 is a diagram illustrating optical output.
FIG. 10 is a diagram illustrating the calculation results of reflectivity.
FIG. 11A is a diagram illustrating slope efficiency.
FIG. 11B is a diagram illustrating slope efficiency.
FIG. 11C is a diagram illustrating slope efficiency.
FIG. 12A is a cross-sectional view illustrating a method of manufacturing a photonic-crystal surface emitting laser.
FIG. 12B is a cross-sectional view illustrating a method of manufacturing a photonic-crystal surface emitting laser.
FIG. 13A is an upper surface view illustrating a photonic-crystal surface emitting laser according to a third embodiment.
FIG. 13B is an upper surface view illustrating a photonic-crystal surface emitting laser according to a fourth embodiment.

DETAILED DESCRIPTION

[Description of Embodiments of Present Disclosure]

First, the contents of embodiments of the present disclosure will be listed and explained.
Specific examples of a photonic-crystal surface emitting laser and a method of manufacturing the same according to embodiments of the present disclosure will be described below with reference to the drawings. The present disclosure is not limited to these examples, and is defined by the scope of the claims, and is intended to include all modifications within the meaning and scope equivalent to the scope of the claims.

<First Embodiment>

(Photonic-crystal Surface Emitting Laser)

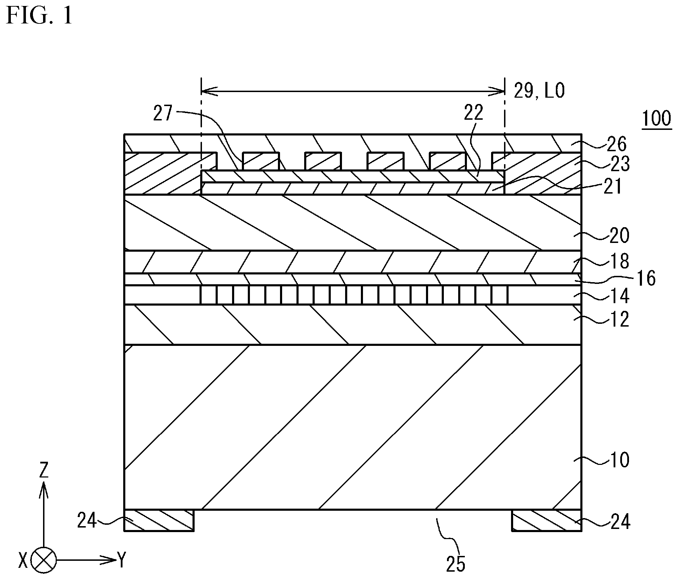

FIG. 1 is a cross-sectional view illustrating a photonic-crystal surface emitting laser 100 according to a first embodiment. As illustrated in FIG. 1, the photonic-crystal surface emitting laser (PCSEL) 100 includes a substrate 10, a cladding layer 12 (first semiconductor layer), a photonic crystal layer 14, a cladding layer 16, an active layer 18, a cladding layer 20 (third semiconductor layer), a semiconductor layer 21, a contact layer 22 (second semiconductor layer), an electrode 24 (first electrode), and an electrode 26 (second electrode). The surface of each layer is parallel to the XY plane. The X-axis, the Y-axis, and the Z-axis are orthogonal to each other.
The semiconductor layers are stacked along the Z-axis. The cladding layer 12, the photonic crystal layer 14, the cladding layer 16, the active layer 18, the cladding layer 20, the semiconductor layer 21, and the contact layer 22 are stacked in this order on the substrate 10. In the XY plane, a portion where the semiconductor layer 21 and the contact layer 22 are provided is referred to as a region 29. The region 29 has a length L0 of, for example, 200 μm.

An insulating film 23 is provided on an upper surface of the contact layer 22 and outside the region 29. The insulating film 23 has a plurality of openings 27 on the contact layer 22 in the region 29. The opening 27 extends through the insulating film 23.

The electrode 26 is provided on an upper surface of the insulating film 23. The electrode 26 is in contact with the upper surface of the insulating film 23. The electrode 26 is in contact with upper surface of the contact layer 22 in the opening 27. The electrode 26 is electrically connected to the contact layer 22. The electrode 26 is filled inside the opening 27. The electrode 24 is in contact with a lower surface of the substrate 10 and is electrically connected to the substrate 10 and the cladding layer 12.

The substrate 10, the cladding layer 12, and the cladding layer 16 are formed of, for example, n-type indium phosphide (n-InP). An n-type dopant is, for example, silicon (Si). A thickness of the cladding layer 12 is, for example, 500 nm. A thickness of the cladding layer 16 is, for example, 100 nm.

The photonic crystal layer 14 is formed of, for example, n-type indium gallium arsenide phosphide (InGaAsP) or aluminum indium gallium arsenide (AlInGaAs). The thickness of the photonic crystal layer 14 is, for example, 300 nm.

The active layer 18 includes a plurality of well layers and barrier layers, and has a Multi Quantum Well (MQW) structure. The well layer and the barrier layer are formed of, for example, undoped indium gallium arsenide phosphide (InGaAsP) or aluminum gallium indium arsenide (AlGaInAs). The active layer 18 has an optical gain.

The cladding layer 20 is formed of, for example, a p-type indium phosphide (p-InP) with a thickness of 3 μm. The semiconductor layer 21 is formed of, for example, p-type indium gallium arsenide phosphide (p-InGaAsP) with a thickness of 100 nm. The contact layer 22 is formed of, for example, p-type indium gallium arsenide (p-InGaAs) with a thickness of 200 nm. A p-type dopant is, for example, zinc (Zn) or carbon (C). The insulating film 23 is formed of an insulator such as silicon nitride (SiN). The materials described above are examples, and each layer may be formed of other materials, or may be formed of a combination of the materials described above and other materials.

The refractive index of the active layer 18 is, for example, 3.5. The refractive index of the cladding layer of InP is, for example, 3.2. The refractive index of InGaAsP, which is the base material of the photonic crystal layer 14, is higher than that of the cladding layer, and is, for example, 3.4.

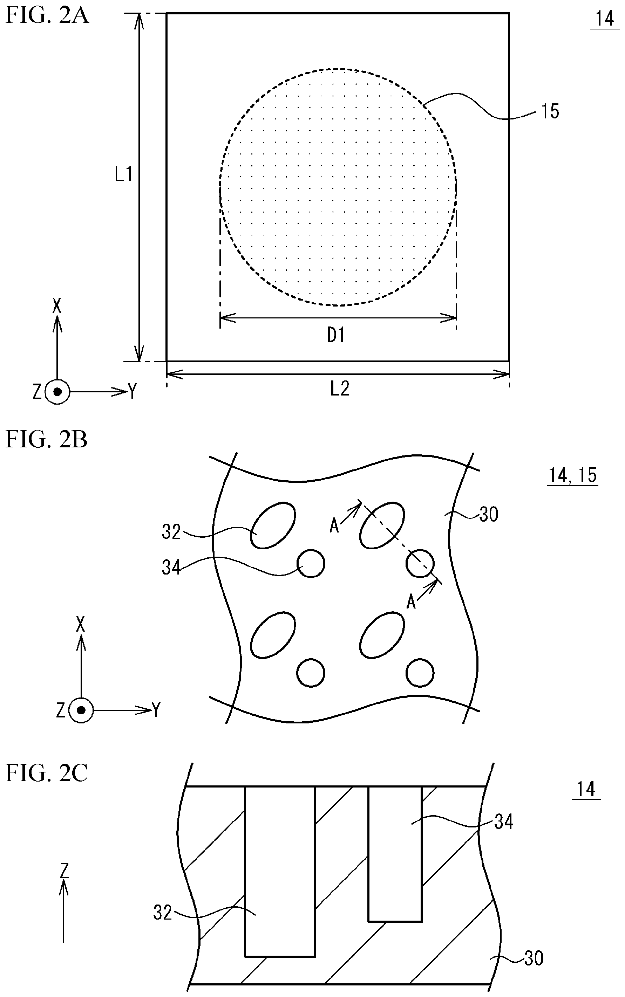

FIG. 2A is a plan view illustrating the photonic crystal layer 14. Lengths L1 and L2 of the sides are, for example, 1000 μm. A region 15 of the photonic crystal layer 14 is located at a center of the photonic crystal layer 14. The region 15 has a circular planar shape. A diameter D1 of the region 15 is, for example, 300 μm. An air hole is provided in the region 15. When the photonic-crystal surface emitting laser 100 is seen through in the Z-axis direction, the region 15 overlaps the region 29 in FIG. 1.

FIG. 2B is an enlarged plan view of the region 15 of the photonic crystal layer 14. FIG. 2C is an enlarged cross-sectional view of the photonic crystal layer 14, illustrating a cross-section taken along a line A-A of FIG. 2B. The photonic crystal layer 14 includes a base material 30 (first region), and is provided with an air hole 32 (second region) and an air hole 34 (second region). The base material 30 is an InGaAsP layer or the like as described above. The plurality of air holes 32 and the plurality of air holes 34 are provided in the base material 30.

As illustrated in FIG. 2B, the plurality of air holes 32 and air holes 34 are disposed two dimensionally. The plurality of air holes 32 are arranged in a square lattice. The plurality of air holes 34 are arranged in a square lattice. The plurality of air holes 32 and the air holes 34 are periodically arranged in the X-axis direction and the Y-axis direction. The lattice parameter is, for example, 400 nm. That is, in the X-axis direction and the Y-axis direction, the distances between the adjacent air holes 32 and between the adjacent air holes 34 are 400 nm. The air hole 32 has an elliptical planar shape. The major axis and the minor axis of the air hole 32 are inclined from the direction in which the plurality of air holes 32 are disposed. The air hole 34 has a circular planar shape.

As illustrated in FIG. 2C, the air hole 32 and the air hole 34 extend in the Z-axis direction. One end of each of the air hole 32 and the air hole 34 is located on one surface of the photonic crystal layer 14. The other end of each of the air hole 32 and the air hole 34 is located in the middle of the photonic crystal layer 14. The air hole 32 and the air hole 34 may extend through the photonic crystal layer 14 and may extend to the cladding layer 12. The air hole 32 is longer than the air hole 34. The inside of each of the air hole 32 and the air hole 34 is air. The refractive index of each of the air hole 32 and the air hole 34 is different from the refractive index of the base material 30. The refractive index periodically changes in a plane of the photonic crystal layer 14.

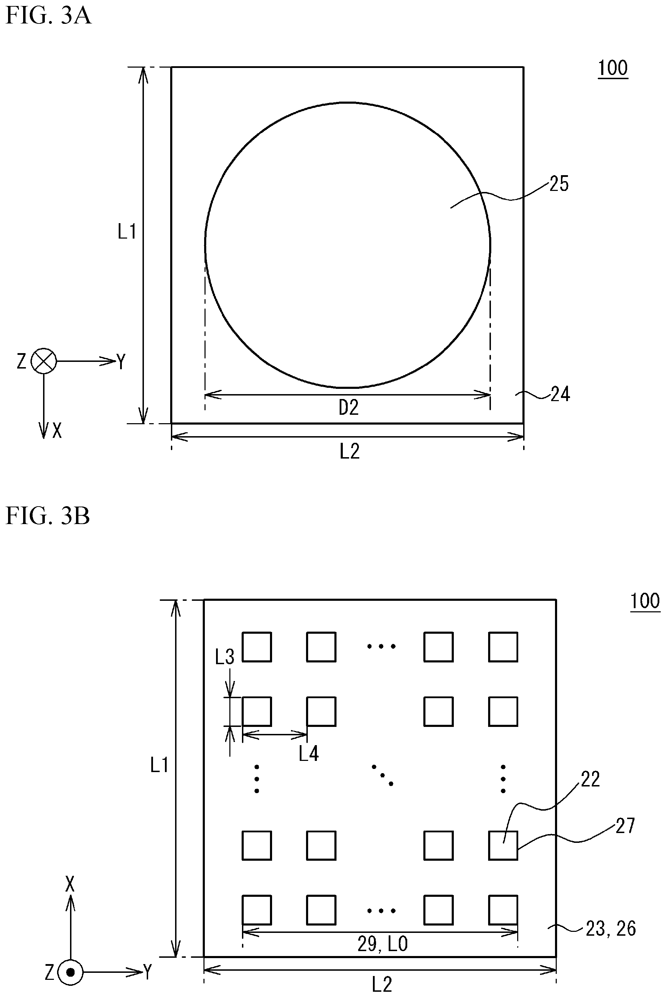

FIG. 3A is a lower surface view illustrating the photonic-crystal surface emitting laser 100. As illustrated in FIG. 3A, an opening 25 is provided in the electrode 24. The opening 25 has a circular planar shape. A diameter D2 of the opening 25 is, for example, 340 μm. The opening 25 extends through the electrode 24, and the substrate 10 is exposed from the opening 25. The opening 25 functions as an aperture for emitting light. A surface of the substrate 10 inside the opening 25 may be covered with an insulating film.

The electrode 24 is an n-type electrode and is in contact with a surface of the substrate 10. The electrode 24 is formed of a metal, and may be formed by stacking, for example, nickel (Ni), germanium (Ge), and gold (Au) in this order from the substrate 10.

FIG. 3B is an upper surface view illustrating the photonic-crystal surface emitting laser 100, and the electrode 26 is seen through. The electrode 26 covers the entire upper surface of the insulating film 23. In the region 29, the plurality of openings 27 are disposed two dimensionally in a plane of the insulating film 23. For example, the opening 27 has a rectangular planar shape. A length L3 of one side of the opening 27 is, for example, 1.6 $\mu$m. A distance (pitch L4) between the corresponding sides of the adjacent openings 27 is, for example, 5 $\mu$m. The area filling factor (FF) of the opening 27 is calculated by the following equation and is about 10%.

$$FF = (L3)^2/(L4)^2$$

The contact layer 22 is exposed from the plurality of openings 27, and the electrode 26 is in contact with the contact layer 22. That is, the electrode 26 has a mesh structure and is periodically in contact with the contact layer 22 in the XY plane. In a region between the openings 27 adjacent to each other, the insulating film 23 is provided between the electrode 26 and the contact layer 22. The electrode 26 is a p-type electrode and is formed by stacking, for example, titanium (Ti), platinum (Pt), and gold (Au) in this order from the contact layer 22. The electrode 26 may also be formed by stacking the Au layer on the Ti layer.

The operation of the photonic-crystal surface emitting laser 100 will be described. Voltage is applied to the photonic-crystal surface emitting laser 100 through the electrode 24 and the electrode 26. Light is generated by the injection of carriers into the active layer 18. Light is diffracted and scattered in a plane of the photonic crystal layer 14, and light having a wavelength corresponding to the period of the air holes 32 and the air holes 34 is amplified, thereby causing laser oscillation. A wavelength of the laser light is, for example, in the 1.3 $\mu$m band or the 1.5 $\mu$m band.

The laser light is emitted in the Z-axis direction. The light propagating downward in FIG. 1 is emitted from the opening 25 of the electrode 24. The light propagating upward is reflected from a lower surface of the electrode 26, propagates downward, and is emitted from the opening 25.

The optical output depends on the reflectivity of the surface of the electrode 26 and the thickness of the insulating film 23. The light reflected from the electrode 26 is emitted, and thus the optical output can be increased.

Heat treatment is performed to electrically connect the electrode 26 to the contact layer 22. The lower surface of the electrode 26 is roughened by the heat treatment, and the reflectivity may be reduced. When the electrode 26 is a solid electrode, the entire lower surface will be in contact with the contact layer 22. Due to the large contact area, rough surfaces are likely to form, which increases the possibility of reduced reflectivity. In the first embodiment, as illustrated in FIG. 1, the electrode 26 is provided on the insulating film 23 and is in contact with the contact layer 22 inside the opening 27. Thus, the contact area between the electrode 26 and the contact layer 22 is reduced. A portion of the electrode 26 in contact with the insulating film 23 is less likely to be roughened even after the heat treatment. Thus, the reflectivity is increased.

The intensity of the emitted light varies in accordance with the phase of the reflected light from the lower surface of the electrode 26 and the phase of the light traveling from the active layer 18 toward the opening 25. When the phases match, the light is strengthened and the optical output is improved. The phase of the reflected light depends on the refractive index and the thickness of the insulating film 23. The phase can be adjusted by appropriately setting the thickness.

(Reflectivity)

The reflectivity of the four samples A, B, C and D were measured. In the sample A, a SiN layer with a thickness of 180 nm, a GaAs substrate with a thickness of 600 $\mu$m, a SiN layer with a thickness of 160 nm, a Ti layer, and an Au layer are stacked in this order. The sample B has the same structure as the sample A except that the SiN layer is not provided between the GaAs layer and the Ti layer. In the sample C, a SiN layer with a thickness of 180 nm, an InP substrate with a thickness of 250 $\mu$m, an InGaAsP layer with a thickness of 40 nm, a C-doped InGaAs layer with a thickness of 70 nm, a SiN layer with a thickness of 100 nm, a Ti layer, a Pt layer, and an Au layer are stacked in this order. The sample D has the same structure as the sample C except that the SiN layer is not provided between the InGaAs layer and the Ti layer.

Light is incident on the SiN layer of each sample, and reflected light is measured to obtain reflectivity. The reflectivity of the sample A is 96%. The reflectivity of the sample B is 79%. The reflectivity of the sample C is 62%. The reflectivity of the sample D is 45%. Each of the sample A and the sample C has the SiN layer between the GaAs layer and the Ti layer. Each of the sample B and the sample D does not have the SiN layer at the position. The reflectivity is increased by providing the SiN layer between the semiconductor layer and the metal.

(Slope Efficiency)

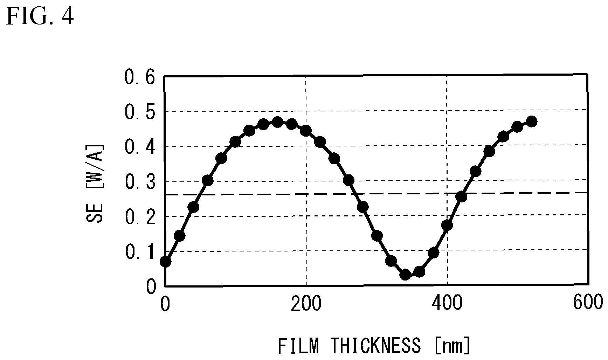

FIG. 4 is a diagram illustrating slope efficiency. The horizontal axis represents a film thickness of the insulating film 23. The vertical axis represents slope efficiency (SE) of the photonic-crystal surface emitting laser 100. A wavelength of light is 1310 nm. The reflectivity of the electrode 26 at the opening 27 is set to 0.5. The refractive index of the insulating film 23 is set to 1.99, and the refractive index of InP is set to 3.2, in order to calculate the slope efficiency.

The dashed line in FIG. 4 corresponds to the case where the reflectivity of the entire electrode 26 is zero. The higher the reflectivity, the higher the slope efficiency. As the slope efficiency is higher, a higher optical output is obtained when the current flowing through the photonic-crystal surface emitting laser 100 is increased. The slope efficiency periodically changes with respect to the change in the film thickness of the insulating film 23. The period of the waveform of the slope efficiency is about 320 nm in terms of the thickness of the insulating film 23. That is, the slope efficiency exhibits a local minimum value at thicknesses of 0 nm and about 320 nm. The slope efficiency exhibits a local maximum value at a thickness of about 160 nm. When the slope efficiency is at the local maximum value, the reflectivity of the entire electrode 26 is 0.5. The phase is adjusted by setting the thickness of the insulating film 23 to an appropriate size. The emitted light from the active layer 18 and the reflected light are strengthened with each other, and thus the optical output can be increased.

(Method of Manufacturing)

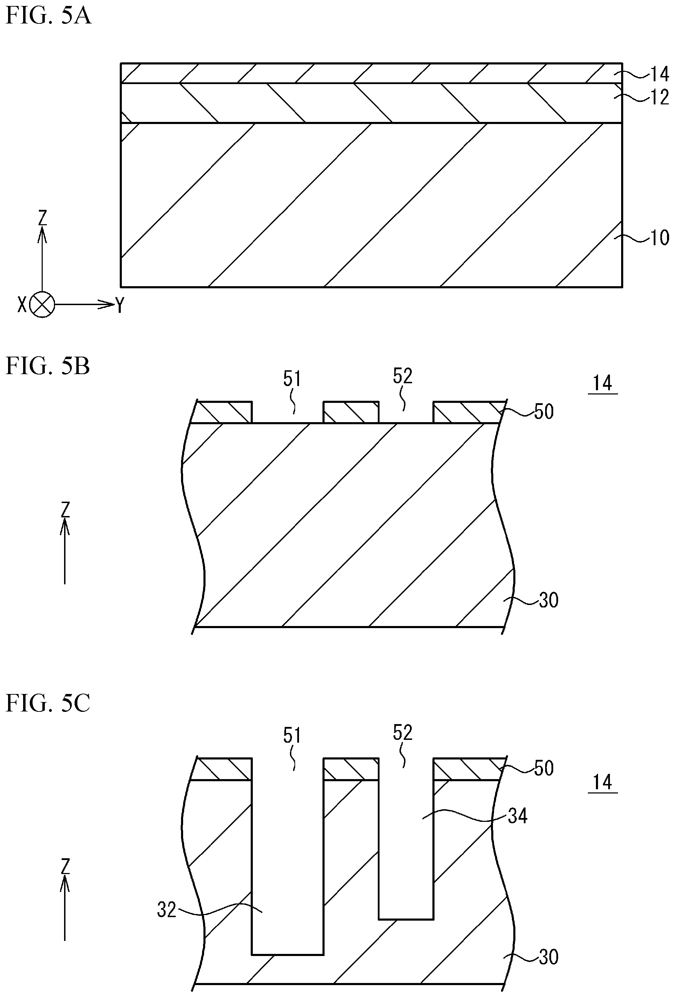

FIG. 5A to FIG. 7B are cross-sectional views illustrating a method of manufacturing the photonic-crystal surface emitting laser 100. As illustrated in FIG. 5A, the cladding layer 12 and the photonic crystal layer 14 are epitaxially grown in this order on the substrate 10 by, for example, Metal Organic Chemical Vapor Deposition (MOCVD) method. In this step, the base material 30 (InGaAsP) of the photonic crystal layer 14 is formed, but an air hole is not formed.

FIG. 5B and FIG. 5C are enlarged views of the photonic crystal layer 14. As illustrated in FIG. 5B, a mask 50 is provided on the upper surface of the photonic crystal layer 14. The mask 50 is formed of an insulator such as SiN. An insulating film is formed on the upper surface of the photonic crystal layer 14. A resist pattern is formed by an electron beam (EB) or the like, and the resist pattern is transferred to the insulating film, thereby forming the mask 50. The mask 50 has an opening 51 and an opening 52. An upper surface of the base material 30 is exposed from the opening 51 and the opening 52. The plurality of openings 51 and the plurality of openings 52 are disposed two dimensionally.

As illustrated in FIG. 5C, the air hole 32 and the air hole 34 are formed in the photonic crystal layer 14 by Reactive Ion Etching (RIE) or the like. The etching proceeds, for example, partway into the photonic crystal layer 14, and does not proceed to a lower surface of the photonic crystal layer 14. The air hole 32 is formed at a position overlapping the opening 51 of the mask 50. The air hole 34 is formed at a position overlapping the opening 52. The planar shapes of the air hole 32 and the air hole 34 are determined by the planar shapes of the opening 51 and the opening 52. By making the opening 51 elliptical and the opening 52 circular, the elliptical air hole 32 and the circular air hole 34 are formed as illustrated in FIG. 2B. After the etching is completed, the mask 50 is removed.

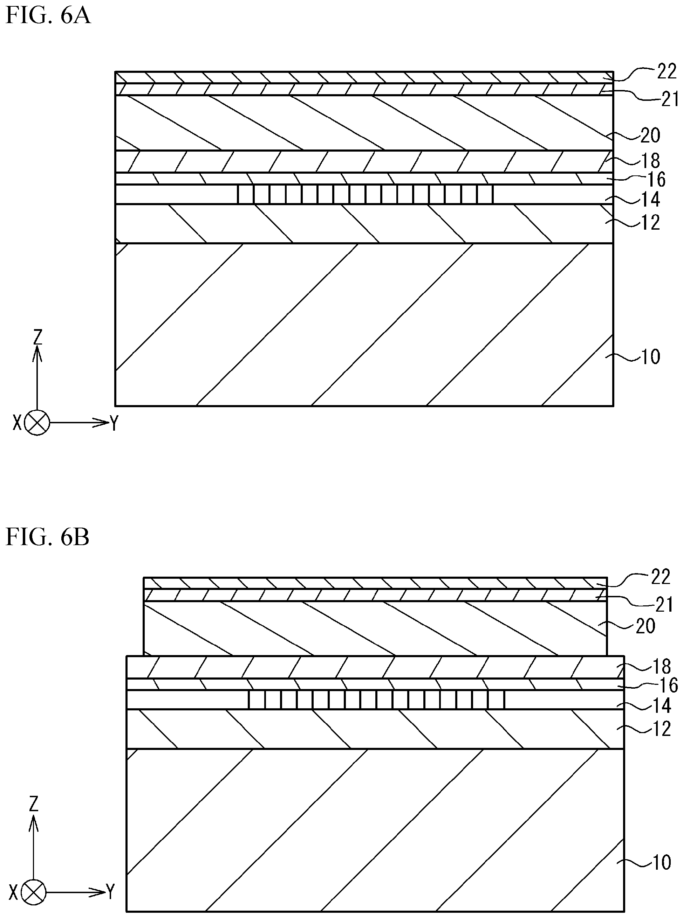

As illustrated in FIG. 6A, the cladding layer 16, the active layer 18, the cladding layer 20, the semiconductor layer 21, and the contact layer 22 are epitaxially grown on the photonic crystal layer 14. The air hole 32 and the air hole 34 are closed by the cladding layer 16. The inside of the air hole is not filled with the cladding layer 16, and becomes a cavity. The active layer 18, the cladding layer 20, the semiconductor layer 21 and the contact layer 22 are epitaxially grown on the flat cladding layer 16. By adjusting the growth conditions, the contact layer 22 is doped with, for example, carbon (C).

As illustrated in FIG. 6B, the outer periphery portions of the contact layer 22, the semiconductor layer 21, and the cladding layer 20 are etched. An upper surface of the active layer 18 is exposed in the etched portion. The thickness from the upper surface of the active layer 18 to the upper surface of the contact layer 22 is measured.

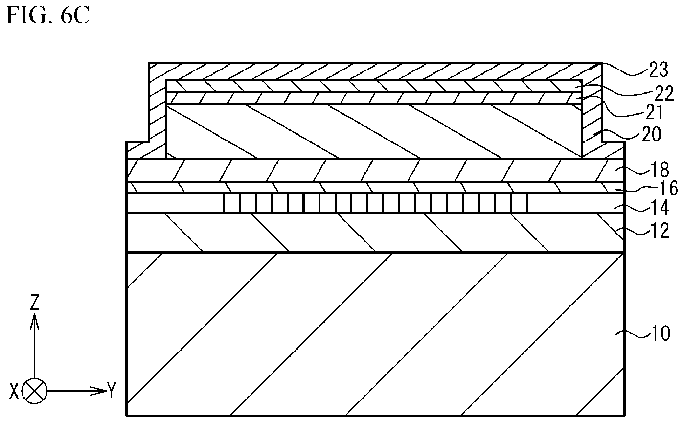

As illustrated in FIG. 6C, the insulating film 23 is formed by, for example, a plasma CVD method (PECVD: Plasma Enhanced CVD). The thickness of the insulating film 23 is determined based on the thickness from the active layer 18 to the contact layer 22.

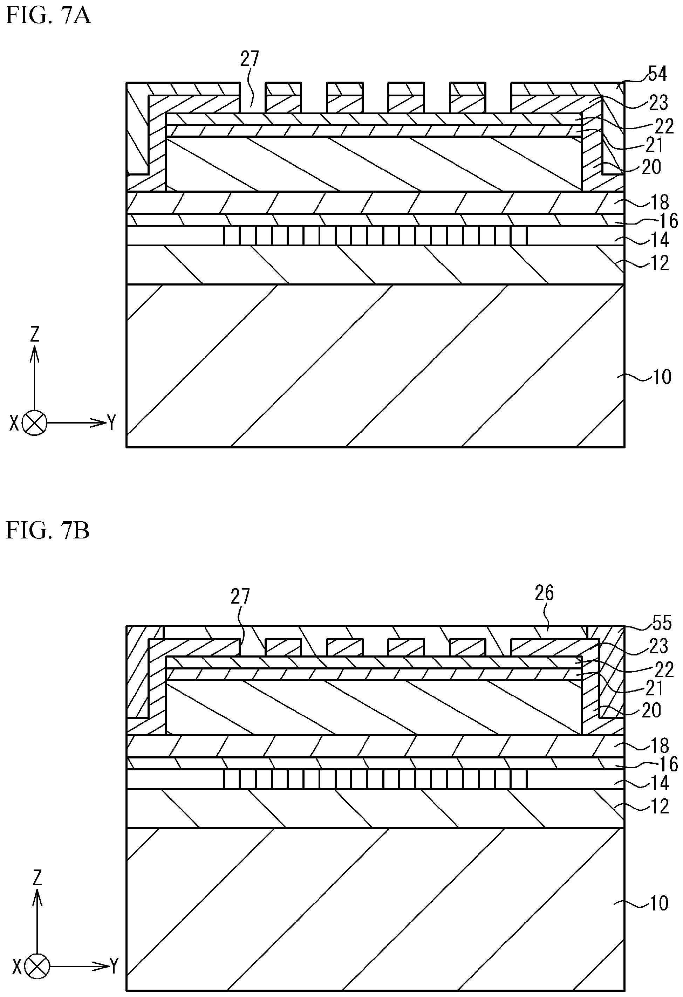

As illustrated in FIG. 7A, a mask 54 is provided on the insulating film 23. As the mask 54, for example, a resist is used. A plurality of openings are provided in the mask 54 by resist patterning. A portion of the insulating film 23 exposed from the mask 54 is removed by dry etching to form the plurality of openings 27. The mask 54 is removed.

As illustrated in FIG. 7B, a mask 55 is provided on the outer periphery portion of the insulating film 23. For example, a resist is used as the mask 55. A portion of the mask 55 overlapping the opening 27 is opened by resist patterning. The electrode 26 is formed by vapor deposition and lift-off. For example, a Ti layer, a Pt layer, and an Au layer are stacked in this order. The mask 55 is removed. As illustrated in FIG. 1, the electrode 24 is provided on the lower surface of the substrate 10, and the opening 25 is formed. For example, heat treatment is performed at a temperature of 300°C or higher to make electrical contact between the electrode and the semiconductor. The wafer is cut along the outer periphery portion as a scribe line. The photonic-crystal surface emitting laser 100 is formed by the above steps.

According to the first embodiment, the insulating film 23 has the plurality of openings 27. As illustrated in FIG. 1, the electrode 26 is provided on the upper surface of the insulating film 23 and is in contact with the upper surface of the contact layer 22 through the opening 27, so as to be electrically connected to the contact layer 22. Since the insulating film 23 is provided between the contact layer 22 and the electrode 26, the contact area between the electrode 26 and the contact layer 22 is reduced. The lower surface of the electrode 26 is less likely to be roughened even after the heat treatment. The reflectivity of the lower surface of the electrode 26 with respect to light is increased. The light is less likely scattered, reflected from the electrode 26, and emitted from the opening 25. The optical output is increased.

The phase of the reflected light is adjusted by setting the thickness of the insulating film 23 to a desired size. When the phase difference between the emitted light from the active layer 18 and the reflected light is $2n\pi$ (n is equal to 0, 1, 2...), the light strengthen each other, and the optical output increases.

For example, in FIG. 6B, the thickness of the semiconductor layers from the active layer 18 to the contact layer 22 is measured before the insulating film 23 is formed. The thickness of the insulating film 23 is determined based on the thickness. The phase of light can be adjusted and the optical output can be increased, by controlling the thickness of the insulating film 23 to an optimal value during manufacturing. For example, in FIG. 4, the thickness at which the slope efficiency is maximized is selected. The thickness of the insulating film 23 is controlled by, for example, the film formation time.

As illustrated in FIG. 3B, the plurality of openings 27 are periodically arranged in the X-axis direction and the Y-axis direction. The electrode 26 and the contact layer 22 are electrically connected through the plurality of openings 27. The current can be injected uniformly into the active layer 18. The openings 27 do not have to be arranged periodically, but there is a possibility that the current is biased. The openings 27 are periodically arranged at the constant pitch L4, so that the current is made nearly uniform.

When the area filling factor (FF) of the plurality of openings 27 in the region 29 is small, the contact area between the electrode 26 and the contact layer 22 is reduced, and the contact resistance is increased. When the FF is large, the contact area increases and the area of the electrode 26 on the insulating film 23 decreases. The lower surface is roughened, and reflectivity is reduced. FF is, for example, 5% to 50%, and may be 10% or more, 20% or more, 40% or less, or 45% or less. Contact resistance can be reduced and reflectivity can be increased.

When the opening 27 is small, the manufacturing becomes difficult. When the opening 27 is large, it is difficult to uniformly inject a current. The opening 27 has a rectangular shape and has the length L3 of, for example, 1 $\mu$m to 10 $\mu$m. The length L3 may be 2 $\mu$m or more, 3 $\mu$m or more, 8 $\mu$m or less, or 9 $\mu$m or less. The opening 27 can be easily manufactured, and a current can be injected uniformly.

The insulating film 23 is formed of SiN, and has a refractive index of 1.99. The phase of light depends on the refractive index and the thickness. The thickness of the insulating film 23 formed of SiN is controlled so that the value which is obtained by dividing the product of the thickness of the insulating film 23 and the refractive index of the insulating film 23 by a wavelength of the light is an integer multiple of $2\pi$. This makes it possible to adjust the phase and increase the reflectivity.

The contact layer 22 is doped with C. By setting the C concentration to $1 \times 10^{19}$ cm$^{-3}$ or more, the contact resistance can be reduced. By increasing the C concentration to, for example, $1 \times 10^{20}$ cm$^{-3}$ or more, the contact resistance between the contact layer 22 and the electrode 26 is reduced to about 1/10 of that in the case of Zn doping.

The substrate 10, the cladding layer 12, the photonic crystal layer 14, and the cladding layer 16 have n-type conductivity. The active layer 18 is a non-doped layer. The cladding layer 20 and the contact layer 22 have p-type conductivity. These layers are stacked to form a p-i-n junction (positive-intrinsic-negative). The electrode 26 is connected to the p-type contact layer 22 in the opening 27. Carriers can be injected into the active layer 18 by applying voltage to the electrodes. The conductivity type may be reversed. An n-type layer is provided on one side of the active layer 18, and a p-type layer is provided on the other side of the active layer 18.

While two types of air holes are used, one type or three or more types may be used. The planar shape of the air hole may be elliptical, circular, or polygonal. In the photonic crystal layer 14, a region having a refractive index different from that of the base material 30 is periodically provided. The region may be an air hole or may be a member different from the base material 30. The photonic crystal layer 14 may be provided between the cladding layer 12 and the cladding layer 20, and may be provided between the cladding layer 12 and the active layer 18 or between the active layer 18 and the cladding layer 20.

\<Second Embodiment\>

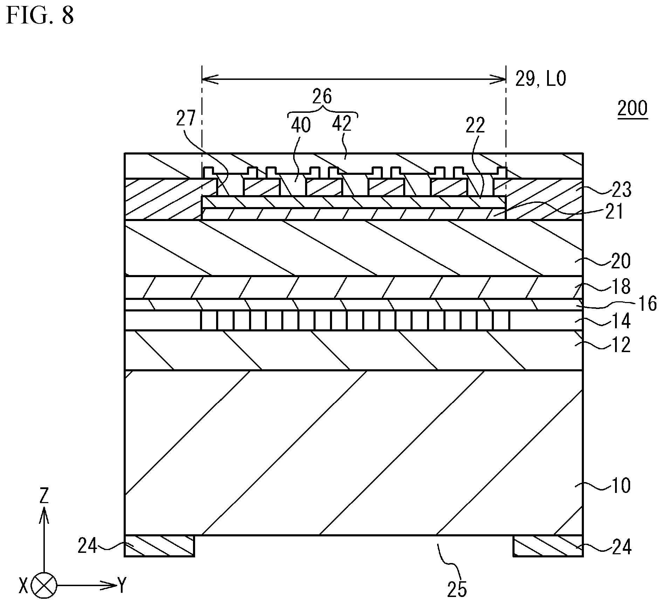

FIG. 8 is a cross-sectional view illustrating a photonic-crystal surface emitting laser 200 according to a second embodiment. The description of the same configuration as that of the first embodiment will be omitted. The electrode 26 includes a plurality of metal layers 40 (first metal layer) and a plurality of metal layers 42 (second metal layer). The metal layer 40 is provided in the opening 27 of the insulating film 23 and is in contact with an upper surface of the contact layer 22. The metal layer 42 is provided on upper surfaces of the insulating film 23 and the metal layer 40, and is in contact with these surfaces.

The metal layer 40 is formed by stacking a Ti layer, a Pt layer, and an Au layer from the contact layer 22. The metal layer 42 is formed by stacking a Ti layer, a Pt layer, and an Au layer from the insulating film 23. The thickness of the Ti layer of the metal layer 42 is thinner than the thickness of the Ti layer of the metal layer 40. The electrode 26 may be formed of a metal other than the above-described metals.

(Slope Efficiency)

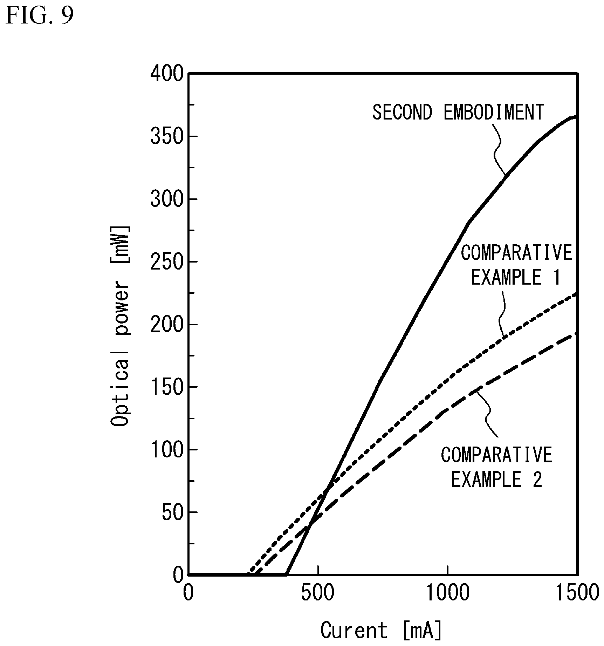

FIG. 9 is a diagram illustrating optical output. The horizontal axis represents the current flowing through the photonic-crystal surface emitting laser. The vertical axis represents optical output. The dotted line represents a comparative example 1. The dashed line represents a comparative example 2. The solid line represents the second embodiment. In the comparative example 1 and comparative example 2, the entire upper surface of the contact layer 22 is exposed from the insulating film 23. The electrode 26 is a solid electrode and is in contact with the entire upper surface of the contact layer 22. The electrode 26 in the comparative example 1 has the same configuration as the metal layer 40. The electrode 26 in the comparative example 2 has the same configuration as the metal layer 42.

As illustrated in FIG. 9, a slope of the second embodiment is greater than slopes of the comparative example 1 and comparative example 2. The slope efficiency of the comparative example 1 is 0.19 W/A, and the maximum optical output is 224 mW. The slope efficiency of the comparative example 2 is 0.17 W/A, and the maximum optical output is 193 mW. The slope efficiency of the second embodiment is 0.41 W/A, and the maximum optical output is 365 mW. According to the second embodiment, the slope efficiency of the photonic-crystal surface emitting laser 200 is twice or more that of the comparative example 1 and comparative example 2. The optical output of the photonic-crystal surface emitting laser 200 can be increased to 300 mW or more.

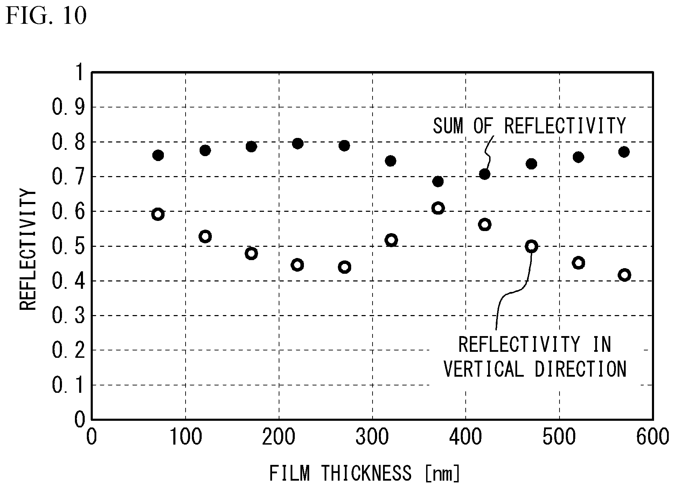

The change in slope efficiency when a thickness of the insulating film 23 is changed is examined. First, the change in reflectivity is calculated. FIG. 10 is a diagram illustrating the calculation results of reflectivity. The horizontal axis represents the thickness of the insulating film 23. The vertical axis represents the reflectivity of the entire lower surface of the electrode 26. The black circles are the sum of reflectivity in all directions. The white circles represent reflectivity in the vertical direction (downward in FIG. 8). The difference between the sum and the vertical reflectivity corresponds to the scattering loss of light. The higher the reflectivity in the vertical direction, the higher the optical output.

The slope efficiency is calculated. The following parameters are used for calculating the slope efficiency. That is, the parameters are an absorption coefficient A, a wavelength $\lambda$ of light, a quantum efficiency $\eta i$, a reflectivity R, a loss $\alpha 0$ of light, losses $\alpha v$ and $\alpha \|$ of light depending on the polarization direction of light, and a phase $\theta$ of light. The phase $\theta$ is expressed by the following equation.

[Equation 1]

$$\theta = 2\pi \times (2T1 \times n1 + 2T2 \times n2 + B) / \lambda$$

T1 is the total film thickness of the plurality of semiconductor layers from the reflection point of the photonic crystal layer 14 to the lower surface of the insulating film 23. T2 is the film thickness of the insulating film 23. n1 is an equivalent refractive index of the semiconductor layer (layers from the substrate 10 to the contact layer 22). n2 is the refractive index of the insulating film 23. B is an adjustment parameter of the phase shift of light.

In the three photonic-crystal surface emitting lasers 200 (from chip E to chip G), the thickness of the insulating film 23 is changed and the slope efficiency is calculated. In the three chips, the refractive index n1 is 3.3, the n2 is 1.78, the total film thickness T1 is 2700 nm, the wavelength is 1330 nm, and the loss $\alpha 0$ is 4.5 cm$^{-1}$. The area filling factor of the opening 27 in the chip E is 10%, the loss $\alpha v$ is 11.5 cm$^{-1}$, and the loss $\alpha\|$ is 9.5 cm$^{-1}$. The area filling factor in the chip F is 13%, the loss $\alpha v$ is 12 cm$^{-1}$, and the loss $\alpha\|$ is 11.5 cm$^{-1}$. The area filling factor in the chip G is 16.8%, the loss $\alpha v$ is 11.5 cm$^{-1}$, and the loss $\alpha\|$ is 18 cm$^{-1}$. The value in the vertical direction in FIG. 10 is used as the reflectivity R.

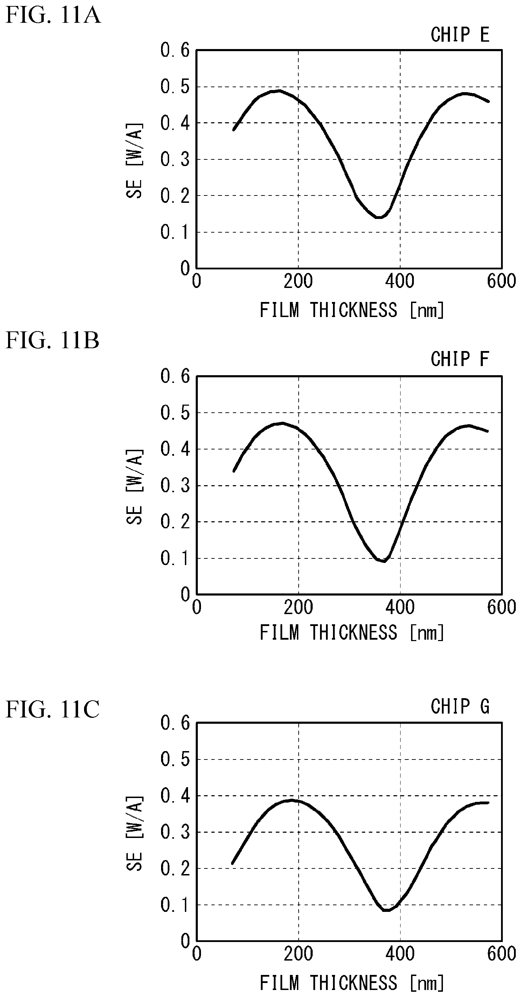

FIG. 11A to FIG. 11C are diagrams illustrating slope efficiency, and show the results of the chip E, the chip F, and the chip G, respectively. The horizontal axis represents the film thickness of the insulating film 23. The vertical axis represents slope efficiency. The solid line represents the calculation result of the slope efficiency. The slope efficiency periodically changes in accordance with the change in the film thickness. The slope efficiency can be calculated with high accuracy by using the Equation 1 and the change in reflectivity as illustrated in FIG. 10.

(Method of Manufacturing)

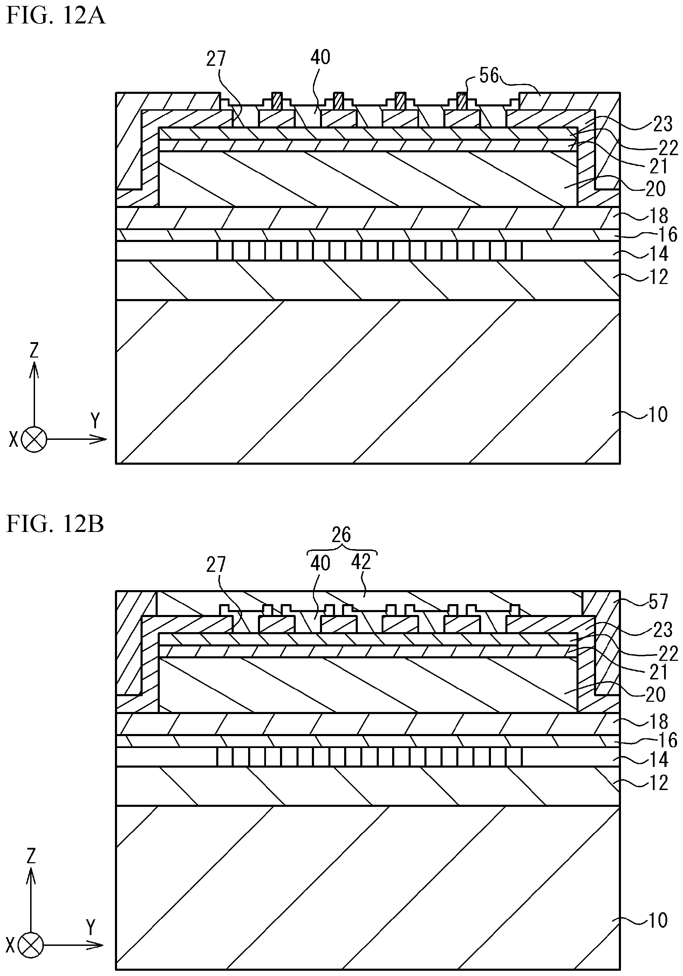

FIG. 12A and FIG. 12B are cross-sectional views illustrating a method of manufacturing the photonic-crystal surface emitting laser 200. The steps up to FIG. 7A are common to the second embodiment. As illustrated in FIG. 12A, a mask 56 is provided on the insulating film 23. A portion of the mask 56 overlapping with the opening 27 is opened by resist patterning. The plurality of metal layers 40 are formed in the openings 27 by vapor deposition and lift-off. Thereafter, the mask 56 is removed.

A mask 57 is provided on an outer periphery portion, and resist patterning is performed. The metal layer 42 is formed on the insulating film 23 and the metal layer 40 by vapor deposition and lift-off. Thereafter, the mask 57 is removed. For example, heat treatment is performed at a temperature of 300°C or higher to make electrical contact between the electrode and the semiconductor. The photonic-crystal surface emitting laser 200 is formed by the above steps.

According to the second embodiment, since the insulating film 23 is provided between the contact layer 22 and the electrode 26, the contact area between the electrode 26 and the contact layer 22 is reduced. The reflectivity increases, resulting in an increase in optical output.

The electrode 26 includes the metal layer 40 and the metal layer 42. The metal layer 40 is in contact with the contact layer 22. The metal layer 42 is located on or above the insulating film 23 and has the reflectivity higher than that of the metal layer 40. Both electrical connection and high reflectivity can be achieved. The Ti layer of the metal layer 42 is thinner than the Ti layer of the metal layer 40. The reflectivity of the metal layer 42 is increased.

As illustrated in FIG. 11A to FIG. 11C, the phase of the reflected light is adjusted by changing the thickness of the insulating film 23. When the phase difference between the emitted light from the active layer 18 and the reflected light is $2n\pi$ (n is equal to 0, 1, 2...), the light strengthen each other, and the optical output increases.

<Third Embodiment>

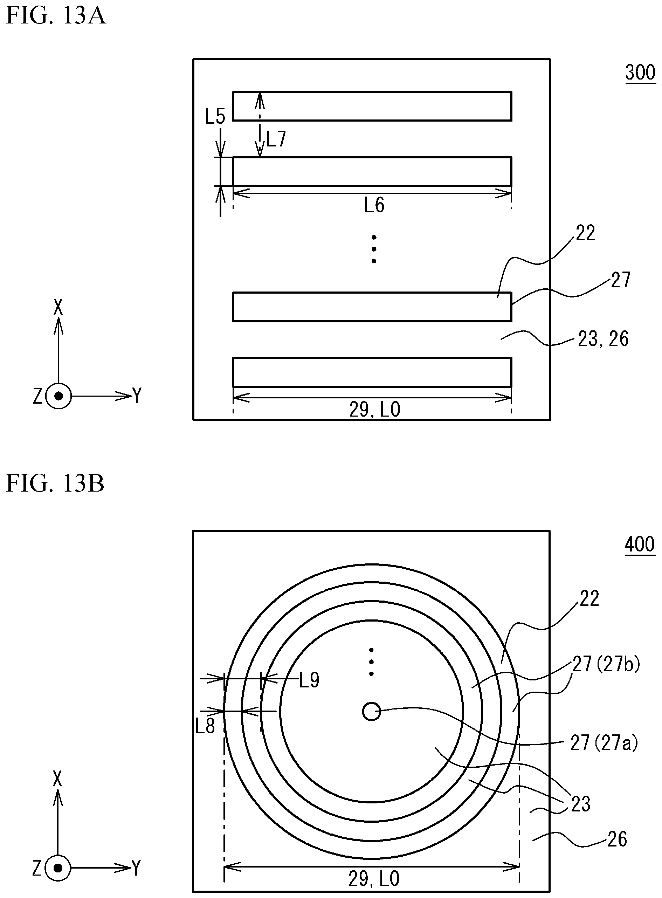

FIG. 13A is an upper surface view illustrating a photonic-crystal surface emitting laser 300 according to the third embodiment, in which the electrode 26 is seen through. The description of the same configuration as that of the first embodiment or the second embodiment will be omitted. The electrode 26 may be the same as that in the first embodiment or the same as that in the second embodiment.

As illustrated in FIG. 13A, the opening 27 has an oblong planar shape. The opening 27 has a length L5 in the X-axis direction of, for example, 1 $\mu$m or more and 10 $\mu$m or less. A length L6 in the Y-axis direction is longer than the length L5 and is, for example, 200 $\mu$m. The openings 27 of the insulating film 23 are periodically arranged in the X-axis direction. A pitch L7 is, for example, 5 $\mu$m. The FF of the opening 27 is 5% to 10%.

According to the third embodiment, the electrode 26 is in contact with an upper surface of the contact layer 22 through the opening 27. The contact area between the electrode 26 and the contact layer 22 is reduced. The reflectivity increases, resulting in an increase in optical output.

<Fourth Embodiment>

FIG. 13B is an upper surface view illustrating a photonic-crystal surface emitting laser 400 according to the fourth embodiment, in which the electrode 26 is seen through. The description of the same configuration as that of the first embodiment or the second embodiment will be omitted. The electrode 26 may be the same as that in the first embodiment or the same as that in the second embodiment.

As illustrated in FIG. 13B, the plurality of openings 27 are concentrically arranged. One opening 27a of the plurality of openings 27 has a circular shape. An opening 27b has a circular ring shape and surrounds the opening 27a. The opening 27 has a width L8 of, for example, 1 $\mu$m to 10 $\mu$m. A pitch L9 is, for example, 5 $\mu$m.

The opening 27, which is located outermost, has an outer diameter of 200 $\mu$m. The FF of the opening 27 is 5% to 10%.

According to the fourth embodiment, the electrode 26 is in contact with the upper surface of the contact layer 22 through the opening 27. The contact area between the electrode 26 and the contact layer 22 is reduced. The reflectivity increases, resulting in an increase in optical output.

The plurality of openings 27 are periodically arranged in a plane of the insulating film 23. The planar shape of the opening 27 may be a shape including polygonal, circular, curve, or the like.

Although the embodiments of the present disclosure have been described in detail, the present disclosure is not limited to the specific embodiments, and various modifications and changes can be made within the scope of the gist of the present disclosure described in the claims.

**Claims**

1. A photonic-crystal surface emitting laser (100, 200, 300,400) comprising:

   a first semiconductor layer (12);
   an active layer (18) stacked over the first semiconductor layer;
   a second semiconductor layer (22) provided opposite to the first semiconductor layer with respect to the active layer;
   a photonic crystal layer (14) provided between the first semiconductor layer and the second semiconductor layer;
   a first electrode (24) electrically connected to the first semiconductor layer;
   an insulating film (23) provided on a surface of the second semiconductor layer opposite to the active layer; and
   a second electrode (26) provided at a surface of the insulating film opposite to the second semiconductor layer,
   wherein the photonic crystal layer has a first region (30) and a plurality of second regions (32, 34) each having a refractive index different from a refractive index of the first region,
   wherein the insulating film has a plurality of openings (27), and
   wherein the second electrode is electrically connected to the second semiconductor layer at the plurality of openings.

2. The photonic-crystal surface emitting laser according to claim 1, wherein the plurality of openings are periodically provided in the surface of the insulating film.

**3.** The photonic-crystal surface emitting laser according to claim 1 or 2, wherein an area filling factor of the plurality of openings to a region where the second semiconductor layer is provided is 5% to 50%.

**4.** The photonic-crystal surface emitting laser according to any one of claims 1 to 3,
wherein the plurality of openings each have a rectangular planar shape and each have a length of 1 μm to 10 μm.

**5.** The photonic-crystal surface emitting laser according to any one of claims 1 to 4,

wherein the second electrode includes a first metal layer (40) and a second metal layer (42), wherein the second metal layer has a reflectivity higher than a reflectivity of the first metal layer, and
wherein the first metal layer is provided at the plurality of openings in the insulating film, and the second metal layer is provided on the surface of the insulating film.

**6.** The photonic-crystal surface emitting laser according to any one of claims 1 to 5, comprising:

a third semiconductor layer (20) provided between the active layer and the second semiconductor layer,
wherein the first semiconductor layer has an n-type conductivity, and
wherein the second semiconductor layer and the third semiconductor layer each have a p-type conductivity.

**7.** A method of manufacturing a photonic-crystal surface emitting laser (100, 200, 300, 400), the method comprising:

stacking an active layer (18) over a first semiconductor layer (12);
forming a photonic crystal layer (14);
forming a second semiconductor layer (22) opposite to the first semiconductor layer with respect to the active layer;
forming a first electrode (24) electrically connected to the first semiconductor layer;
forming an insulating film (23) on a surface of the second semiconductor layer opposite to the active layer;
forming a plurality of openings (27) in the insulating film; and
forming a second electrode (26) at a surface of the insulating film opposite to the second semiconductor layer,
wherein the photonic crystal layer has a first region (30) and a plurality of second regions (32, 34) each having a refractive index different from a refractive index of the first region, and wherein the second electrode is electrically connected to the second semiconductor layer at the plurality of openings.

**8.** The method of manufacturing a photonic-crystal surface emitting laser according to claim 7, the method comprising:

stacking a third semiconductor layer (20) on the active layer,
wherein the second semiconductor layer is stacked over the third semiconductor layer, and
wherein, in the forming of the insulating film, forming the insulating film having a thickness determined based on a thickness from the active layer to the second semiconductor layer.

FIG. 1

FIG. 2A

FIG. 2B

FIG. 2C

FIG. 3A

FIG. 3B

FIG. 4

FIG. 5A

FIG. 5B

FIG. 5C

FIG. 6A

FIG. 6B

FIG. 6C

FIG. 7A

FIG. 7B

FIG. 8

FIG. 9

FIG. 10

FIG. 11A

CHIP E

FIG. 11B

CHIP F

FIG. 11C

CHIP G

FIG. 12A

FIG. 12B

FIG. 13A

FIG. 13B

**Europäisches Patentamt**
**European Patent Office**
**Office européen des brevets**

# EUROPEAN SEARCH REPORT

**Application Number**

EP 25 18 6220

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/163566 A1 (NODA SUSUMU [JP] ET AL) 25 May 2023 (2023-05-25) | 1,2,6-8 | INV. H01S5/20 |
| Y | * paragraph [0080] - paragraph [0097]; figures 1-5B * | 3-5 | H01S5/187 H01S5/11 H01S5/042 |
| X | WO 2023/171629 A1 (HAMAMATSU PHOTONICS KK [JP]) 14 September 2023 (2023-09-14) | 1,7 | |
| Y | * figures 1,7 * & US 2025/079792 A1 (OTE KIBO [JP] ET AL) 6 March 2025 (2025-03-06) * paragraph [0062] - paragraph [0066]; figure 1 * * paragraph [0086] - paragraph [0093]; figure 7 * | 3-5 | |
| X | US 2023/090522 A1 (JIROKU HIROAKI [JP] ET AL) 23 March 2023 (2023-03-23) | 1,2,7 | |
| Y | * paragraph [0028] - paragraph [0063]; figures 1-4 * | 3-5 | |
| Y | JP 2006 156944 A (RICOH KK) 15 June 2006 (2006-06-15) * paragraph [0035] - paragraph [0056]; figures 1,2,6 * | 5 | TECHNICAL FIELDS SEARCHED (IPC) H01S |
| X | US 2020/028327 A1 (NODA SUSUMU [JP] ET AL) 23 January 2020 (2020-01-23) * paragraph [0108] - paragraph [0116]; figures 17A,B * | 1 | |

The present search report has been drawn up for all claims

| Place of search | Date of completion of the search | Examiner |
|---|---|---|
| Munich | 26 November 2025 | Hervé, Denis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 6220

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2025

| Patent document cited in search report | Publication date | Patent family member(s) | | Publication date |
|---|---|---|---|---|
| US 2023163566 A1 | 25-05-2023 | EP | 4131675 A1 | 08-02-2023 |
| | | JP | 7624742 B2 | 31-01-2025 |
| | | JP | WO2021200994 A1 | 07-10-2021 |
| | | US | 2023163566 A1 | 25-05-2023 |
| | | WO | 2021200994 A1 | 07-10-2021 |
| WO 2023171629 A1 | 14-09-2023 | CN | 118891792 A | 01-11-2024 |
| | | DE | 112023001278 T5 | 13-03-2025 |
| | | JP | 2023131320 A | 22-09-2023 |
| | | US | 2025079792 A1 | 06-03-2025 |
| | | WO | 2023171629 A1 | 14-09-2023 |
| US 2023090522 A1 | 23-03-2023 | JP | 2023041231 A | 24-03-2023 |
| | | US | 2023090522 A1 | 23-03-2023 |
| JP 2006156944 A | 15-06-2006 | JP | 4594814 B2 | 08-12-2010 |
| | | JP | 2006156944 A | 15-06-2006 |
| US 2020028327 A1 | 23-01-2020 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016031966 A